# EUROPEAN PATENT APPLICATION

(11) **EP 4 827 282 A1**
(43) Date of publication of application: **21.10.2026**
(21) Application number: 25215524.7
(22) Date of filing: 13.11.2025
(51) Int. Cl.: H10F 77/70, H10F 77/20

(54) **0-BUSBAR SOLAR CELL AND PHOTOVOLTAIC MODULE**

(30) Priority: 17.04.2025 CN 202510486892
(71) Applicant: JINKO SOLAR CO., LTD, ShangRao, Jiangxi 334100 (CN); Zhejiang Jinko Solar Co., Ltd., Haining, Zhejiang 314416 (CN)
(72) Inventor: WANG, Luchuang, JIANGXI (CN); PENG, Yingying, JIANGXI (CN); ZHANG, Ningbo, JIANGXI (CN); CHEN, Zhendong, JIANGXI (CN); LIN, Yao, JIANGXI (CN); REN, Qianqian, JIANGXI (CN)
(74) Representative: Algemeen Octrooi- en Merkenbureau B.V.

(57) **Abstract**

The present disclosure relates to a 0-busbar solar cell (10) and a photovoltaic module (100). The 0-busbar solar cell (10) includes a substrate (11) provided with fingers (12). The fingers (12) are arranged at intervals along a first direction (X). A connection part (13) is disposed between two adjacent fingers (12). The connection part (13) is connected to the fingers (12). The connection part (13) is configured to be connected to a solder strip (20). The connection part (13) includes a first connection portion (131) and second connection portions (132) connected to two ends of the first connection portion (131) along the first direction. A dimension of the second connection portion (132) in a second direction gradually decreases along a direction away from the first connection portion (131). The finger (12) is connected to an end of the second connection portion (132) away from the substrate along a third direction (Z). By arranging the connection part, the possibility of breakage of the finger caused by stress concentration at a joint between the finger and the solder strip is reduced, enabling a stable and reliable connection between the solder strip (20) and the 0-busbar solar cell (10). The width of the second connection portion (132) gradually decreases along a direction towards the finger (12), which reduces the light shielding area of the connection part and improves the photoelectric conversion efficiency of the 0-busbar solar cell.

## Description

### TECHNICAL FIELD

The present disclosure relates to the technical field of photovoltaic, and in particular, to a 0-busbar solar cell and a photovoltaic module.

### BACKGROUND

Currently, when a finger of a 0-busbar solar cell is connected to a solder strip, the finger is prone to issues such as breakage, which affects the reliability of the connection between the finger and the solder strip, thereby further affecting the performance of the 0-busbar solar cell and the photovoltaic module.

### SUMMARY

In view of this, the present disclosure provides a 0-busbar solar cell and a photovoltaic module, so as to solve the above-mentioned technical problems of low reliability of connection between a finger and a solder strip in the related art. The invention is set out in the appended set of claims.

In a first aspect, one or more embodiments of the present disclosure provides a 0-busbar solar cell, including a substrate. The substrate is provided with fingers, the fingers are arranged at intervals along a first direction, a connection part is disposed between and connected to two adjacent fingers, and the connection part is configured to be connected to a solder strip. The connection part includes a first connection portion and second connection portions, the second connection portions are connected to two ends of the first connection portion along the first direction, a dimension of each of the two second connection portions in a second direction gradually decreases along a direction away from the first connection portion, and the finger is connected to an end of each of the two second connection portions away from the substrate along a third direction.

In a possible embodiment, a projection of the first connection portion along the third direction is rectangular; and a dimension of the first connection portion along the first direction is greater than a dimension of the first connection portion along the second direction.

In a possible embodiment, a dimension a of the first connection portion along the first direction satisfies: 0.4mm≤a≤1.2mm, and/or a dimension b of the first connection portion along the second direction satisfies: 0.04mm≤b≤0.2mm.

In a possible embodiment, the second connection portion includes a first edge and a second edge, the first edge includes a first reference point, the second edge includes a second reference point, and the first reference point and the second reference point are arranged along the second direction; and a distance between the first reference point and the second reference point is h; a distance from each of the first reference point and the second reference point to the first connection portion along the first direction is d; a dimension of the first connection portion along the second direction is b; where h, d and b satisfy h=-kd+b, and k is within a range of -0.08≤k≤1.

In a possible embodiment, a dimension c of the second connection portion along the first direction is within a range of 0.1mm≤c≤0.5mm.

In a possible embodiment, along the first direction, the dimension of the first connection portion is greater than a dimension of the solder strip.

In a possible embodiment, along the first direction, a dimension of the connection part is greater than a dimension of the solder strip, and a dimension of the first connection portion is smaller than a dimension of the solder strip.

In a possible embodiment, a dimension H of the connection part along the third direction is within a range of 3µm≤H≤8µm.

In a possible embodiment, a dimension W of the finger along the second direction is within a range of 10µm≤W≤20µm.

In a second aspect, one or more embodiments of the present disclosure provides a photovoltaic module, including a cover plate, an encapsulation layer, and a solar cell string. The cover plate is connected to the solar cell string through the encapsulation layer; and the solar cell string includes a plurality of 0-busbar solar cells according to any one of claims 1 to 9, adjacent 0-busbar solar cells are connected to each other through a solder strip. The solder strip is soldered to the connection part to electrically connect the solder strip and the finger.

The present disclosure has the following beneficial effects. According to one or more embodiments of the present disclosure, by arranging the connection part, the solder strip is connected to the finger through alloying with the connection part. That is, the finger does not need to be directly soldered to the solder strip, reducing the possibility of breakage of the finger caused by stress concentration at the joint between the finger and the solder strip. Additionally, the connection part may effectively disperse the pressure generated by the solder strip during soldering, improving the stability and reliability of solder strip soldering, thereby achieving the stable and reliable connection between the solder strip and the 0-busbar solar cell, and thus ensuring the normal operation of the photovoltaic module. The width of the second connection portion of the connection part gradually decreases along a direction towards the finger, thereby reducing the light shielding area of the connection part while ensuring the stable connection between the connection part and the finger, thereby reducing the light shielding loss of the 0-busbar solar cell, improving the photoelectric conversion efficiency of the 0-busbar solar cell, reducing the amount of metal paste required for printing the connection part, and thus lowering the production cost of the 0-busbar solar cell.

The finger is formed on the side of the connection part away from the substrate along the third direction. That is, the finger is connected to the second connection portion at a position above the second connection portion, thereby facilitating increasing the contact area between the finger and the connection part, improving the stability and reliability of the connection between the finger and the connection part, and thus realizing the stable current transmission. Additionally, the finger and the connection part also realize current transmission in the third direction, thereby facilitating reducing the influence of breakage of the finger on the current transmission performance, thus ensuring the reliability of the 0-busbar solar cell. On the other hand, arranging the connection part under the finger reduces the possibility of the finger deforming or breaking under the soldering pressure of the solder strip when the connection part is connected to the solder strip. Additionally, after the connection part is formed on the substrate, the connection part can play a positioning role during printing the finger, improving the positional accuracy of the finger, and thus improving the quality of the 0-busbar solar cell.

It should be understood that the general description above and the detailed description in the following are merely illustrative, and cannot limit the present disclosure.

### BRIEF DESCRIPTION OF DRAWINGS

In order to better illustrate the technical solutions in embodiments of the present disclosure, the drawings used in the description of embodiments are briefly described as below. It will be apparent that the drawings described below are merely some embodiments of the present disclosure, and other drawings may be obtained by those skilled in the art according to these drawings without paying any creative efforts.
FIG. 1 is a partial schematic diagram of a 0-busbar solar cell according to one or more embodiments of the present disclosure;
FIG. 2 is a schematic structural diagram of a connection part according to one or more embodiments of the present disclosure;
FIG. 3 is a partial schematic diagram of connection between a connection part and a solder strip according to one or more embodiments of the present disclosure;
FIG. 4 is a partial schematic diagram of connection between a connection part and a solder strip according to one or more embodiments of the present disclosure;
FIG. 5 is a schematic diagram of a photovoltaic module according to one or more embodiments of the present disclosure; and
FIG. 6 is a schematic diagram of two adjacent 0-busbar solar cells connected by a solder strip according to one or more embodiments of the present disclosure.

### Reference signs:

100 - photovoltaic module; 10 - 0-busbar solar cell; 11 - substrate; 12 - finger; 13 - connection part; 131 - first connection portion; 132 - second connection portion; 132a - first edge; 132b - second edge; 20 - solder strip; 30 - first cover plate; 40 - second cover plate; 50 - first encapsulation layer; 60 - second encapsulation layer; 70 - solar cell string; P1 - first reference point; P2 - second reference point.

### DESCRIPTION OF EMBODIMENTS

In order to better illustrate the technical solutions of the present disclosure, embodiments of the present disclosure are described in detail below in conjunction with the drawings.

It should be noted that the described embodiments are only some rather than all of embodiments of the present disclosure. Based on the embodiments of the present disclosure, all other embodiments obtained by those ordinary skilled in the art without creative efforts shall fall within the protection scope of the present disclosure.

The terms used in embodiments of the present disclosure are only for the purpose of describing specific embodiments, and are not intended to limit the present disclosure. As used in embodiments of the present disclosure and the appended claims, the singular forms "a/an", "said", and "the" are intended to include the plural forms as well, unless the context clearly indicated otherwise.

It should be understood that the term "and/or" used in the context of the present disclosure is to describe a correlation relation of related objects, indicating that there may be three relations, e.g., A and/or B may indicate only A, both A and B, and only B. In addition, the symbol "/" in the context generally indicates that the relation between the objects in front and at the back of "/" is an "or" relationship.

A solar cell can convert solar energy into electric energy, and may adopt a 0-busbar (0BB) technology, which replaces an original busbar with a solder strip. That is, the solder strip is directly connected to the finger to realize the current transmission. There is no need to provide a busbar, thereby reducing the consumption of the metal paste, and thus reducing the production cost of the photovoltaic module. Due to the relatively small width of the finger, the finger is prone to breakage or cold soldering during soldering with the solder strip, thereby affecting the performance of the 0-busbar solar cell and further affecting the reliability of the photovoltaic module.

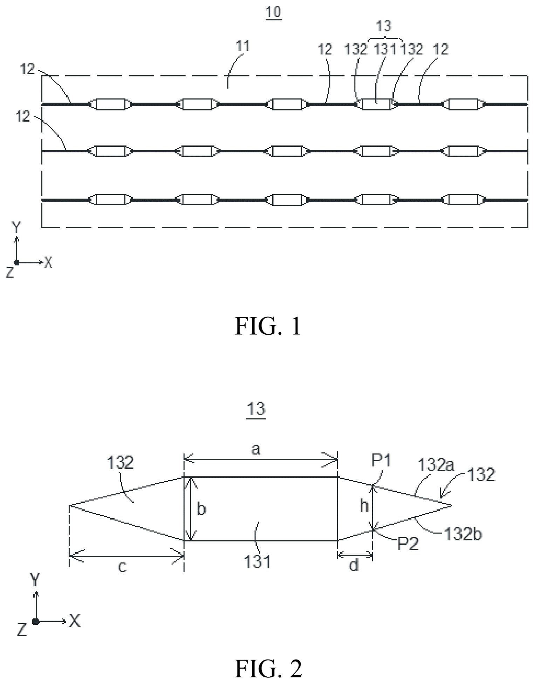

As shown in FIG. 1, one or more embodiments of the present disclosure provides a 0-busbar solar cell 10. The 0-busbar solar cell 10 includes a substrate 11. Fingers 12 are disposed on the substrate 11, and are arranged at intervals along a first direction X. A connection part 13 is disposed between two adjacent fingers 12. The connection part 13 is connected to the finger 12, and is configured to be connected to a solder strip (not shown in the figure). The connection part 13 includes a first connection portion 131 and second connection portions 132. The second connection portions 132 are connected to two ends of the first connection portion 131 along the first direction X. A dimension of the second connection portion 132 along a second direction Y gradually decreases in a direction away from the first connection portion 131. The finger 12 is connected to an end of the second connection portion 132 away from the substrate 11 along a third direction Z.

The first direction X intersects with the second direction Y, and both the first direction X and the second direction Y are perpendicular to the third direction Z. The first direction X may be a length direction of the 0-busbar solar cell 10, the second direction Y may be a width direction of the 0-busbar solar cell 10, and the third direction Z may be a thickness direction of the 0-busbar solar cell 10.

The substrate 11 is provided with a plurality of fingers 12 and a plurality of connection parts 13. The connection parts 13 and the fingers 12 can be formed on the substrate 11 by printing metal paste. The connection parts 13 and the fingers 12 can be in ohmic contact with the substrate 11. The fingers 12 are spaced apart along the first direction X and the second direction Y. The connection parts 13 are distributed at positions corresponding to the solder strip to facilitate connection with the solder strip. Along the first direction X, the connection part 13 is located between two adjacent fingers 12, and two ends of the connection part 13 are respectively connected to the corresponding fingers 12, enabling the two adjacent fingers 12 to be electrically connected to each other through the connection part 13.

The connection part 13 includes a first connection portion 131 and a second connection portion 132 arranged along the first direction X. The second connection portion 132 is connected to each of two ends of the first connection portion 131 and connected to the corresponding finger 12. A width of the second connection portion 132 (that is, a dimension of the second connection portion 132 along the second direction Y) gradually decreases in a direction away from the first connection portion 131, enabling a shape of the second connection portion 132 to be approximately a triangle. Along the third direction Z, an end of the finger 12 is located above and connected to an end of the second connection portion 132. That is, the finger 12 and the second connection portion 132 have an overlapping portion in the third direction Z.

During the forming process of the photovoltaic module, the solder strip is soldered to the connection part 13, that is, the solder strip is alloyed with the connection part 13, so that the current collected by the finger 12 is transmitted to the solder strip through the connection part 13 and then output through the solder strip. That is, the solder strip is electrically connected to the finger 12 through the connection part 13. Compared with a solution in the related art in which the finger 12 of the 0-busbar solar cell 10 is directly soldered to the solder strip, according to one or more embodiments of the present disclosure, by arranging the connection part 13, the solder strip is connected to the finger 12 through alloying with the connection part 13. That is, the finger 12 does not need to be directly soldered to the solder strip, thereby reducing the possibility of breakage of the finger 12 caused by stress concentration at the joint between the finger 12 and the solder strip. Additionally, the connection part 13 may effectively disperse the pressure generated by the solder strip during soldering, improving the stability of solder strip soldering, thereby achieving the stable and reliable connection between the solder strip and the 0-busbar solar cell 10, and thus ensuring the normal operation of the photovoltaic module.

The width of the second connection portion 132 of the connection part 13 gradually decreases along a direction towards the finger 12, thereby reducing the light shielding area of the connection part 13 while ensuring the stable connection between the connection part 13 and the finger 12, thereby reducing the light shielding loss of the 0-busbar solar cell 10, improving the photoelectric conversion efficiency of the 0-busbar solar cell 10, reducing the amount of metal paste required for printing the connection part 13, and thus lowering the production cost of the 0-busbar solar cell 10.

During the forming process of the 0-busbar solar cell 10, the connection part 13 may be printed on the substrate 11 first, and then the finger 12 may be printed on the substrate 11 with the connection parts 13, so that the finger 12 is formed on a side of the connection part 13 away from the substrate 11 along the third direction Z. That is, the finger 12 is connected to the second connection portion 132 at a position above the second connection portion 132, thereby facilitating increasing the contact area between the finger 12 and the connection part 13, improving the stability and reliability of the connection between the finger 12 and the connection part 13, and thus realizing the stable current transmission. Additionally, the finger 12 and the connection part 13 also realize current transmission in the third direction Z, thereby facilitating reducing the influence of breakage of the finger 12 on the current transmission performance, thus ensuring the reliability of the 0-busbar solar cell 10. On the other hand, arranging the connection part 13 under the finger 12 reduces the possibility of the finger 12 deforming or breaking under the soldering pressure of the solder strip when the connection part 13 is connected to the solder strip. Additionally, after the connection part 13 is formed on the substrate 11, the connection part can play a positioning role during printing the finger 12, improving the positional accuracy of the finger 12, and thus improving the quality of the 0-busbar solar cell 10.

As shown in FIG. 2, in one or more embodiments, a projection of the first connection portion 131 along the third direction Z is rectangular, and a dimension of the first connection portion 131 along the first direction X is greater than a dimension of the first connection portion 131 along the second direction Y.

In the photovoltaic module, two adjacent 0-busbar solar cells 10 are connected through the solder strip. The first connection portion 131 is designed as a rectangle, a long edge of the rectangle extends along the first direction X, and a short edge of the rectangle extends along the second direction Y, so as to increase the contact area between the connection part 13 and the solder strip, and to realize the stable and reliable connection between the connection part 13 and the solder strip, thereby improving the stability and reliability of the connection between adjacent 0-busbar solar cells 10, and ensuring normal and stable transmission of current, and thus improving the reliability of the photovoltaic module.

In some other embodiments, the first connection portion may be formed in other shapes such as a circle, a polygon, which may be specifically designed according to actual usage requirements of the 0-busbar solar cell.

As shown in FIG. 2, in one or more embodiments, a dimension a of the first connection portion 131 along the first direction X is within a range of 0.4mm≤a≤1.2mm, and/or a dimension b of the first connection portion 131 along the second direction Y is within a range of 0.04mm≤b≤0.2mm.

The length (i.e., the dimension along the first direction X) a of the first connection portion 131 may be 0.4mm, 0.5mm, 0.6mm, 0.7mm, 0.8mm, 0.9mm, 1mm, 1.1mm or 1.2mm, or may be other values within the above-mentioned range. The width (i.e., the dimension along the second direction Y) b of the first connection portion 131 may be 0.04mm, 0.05mm, 0.06mm, 0.08mm, 0.1mm, 0.12mm, 0.14mm, 0.16mm, 0.18mm or 0.2mm, or may be other values within the above-mentioned range.

If the dimension of the first connection portion 131 is too large, the light shielding area of the connection part 13 is too large, thereby affecting the photoelectric conversion efficiency of the 0-busbar solar cell 10. If the dimension of the first connection portion 131 is too small, the current collection and transmission performance of the connection part 13 is affected, and additionally, the contact area between the connection part 13 and the solder strip is also reduced, thereby affecting the connection stability of the solder strip, and thus affecting the reliability of the 0-busbar solar cell 10 and the whole photovoltaic module. Therefore, by configuring the dimension of the first connection portion 131 along the first direction X and the dimension of the first connection portion 131 along the second direction Y as described above, it is beneficial to improving the connection stability of the solder strip while ensuring the current collection and transmission performance of the connection part 13, reducing the light shielding area of the connection part 13, and thus improving the photoelectric conversion efficiency of the photovoltaic module.

As shown in FIG. 2, in one or more embodiments, the second connection portion 132 includes a first edge 132a and a second edge 132b. The first edge 132a includes a first reference point P1. The second edge 132b includes a second reference point P2. The first reference point P1 and the second reference point P2 are arranged along the second direction Y. A distance between P1 and P2 is h. A distance from each of the first reference point P1 and the second reference point P2 to the first connection portion 131 along the first direction X is d. A dimension of the first connection portion 131 along the second direction Y is b, and h, d and b satisfy: h=-kd+b, where k is within a range of-0.08≤k≤1. For example, k may be -0.08, -0.06, -0.04, -0.02, 0.02, 0.04, 0.06, 0.08, or 1, or may be other values within the above-mentioned range. In some embodiments, k may not be 0.

As mentioned above, the dimension of the second connection portion 132 along the second direction Y gradually decreases in the direction away from the first connection portion 131. That is, the distance h between the first reference point P1 and the second reference point P2 along the second direction Y changes with the change of the distance d between the first reference point P1 and the second reference point P2 to the first connection portion 131 along the first direction X. For each determined value of d, h has a uniquely determined value corresponding thereto.

In some embodiments, d and h may be 0. When d=0, a distance h between the first reference point P1 and the second reference point P2 is equal to a dimension b of the first connection portion 131 along the second direction Y. When h=0, that is, the first reference point P1 overlaps with the second reference point P2, a distance from each of the first reference point P1 and the second reference point P2 to the first connection portion 131 along the first direction X is d, and the distance d is equal to the length c of the second connection portion 132.

The above-mentioned design limits the shape of the second connection portion 132, which can be understood as limiting the area of the second connection portion 132, thereby ensuring that the second connection portion 132 has a sufficient area to connect with the finger 12, that is, ensuring a sufficient contact area between the second connection portion 132 and the finger 12, thus improving the stability and reliability of the connection between the finger 12 and the second connection portion 132, reducing the possibility of breakage of the finger 12, further realizing the stable current transmission and ensuring the reliability of the 0-busbar solar cell 10.

As shown in FIG. 2, in one or more embodiments, a dimension c of the second connection portion 132 along the first direction X is within a range of 0.1mm≤c≤0.5mm.

The length c (i.e., the dimension along the first direction X) of the second connection portion 132 may be 0.1mm, 0.15mm, 0.2mm, 0.25mm, 0.3mm, 0.35mm, 0.4mm, 0.45mm or 0.5mm, or may be other values within the above-mentioned range. If the length of the second connection portion 132 is too large, the light shielding area of the connection part 13 is likely to be too large, which affects the photoelectric conversion efficiency of the 0-busbar solar cell 10. If the length of the second connection portion 132 is too small, the current transmission performance of the connection part 13 is affected, and additionally, the contact area between the connection part 13 and the solder strip and the contact area between the connection part 13 and the finger 12 are also reduced, thereby affecting the connection stability of the solder strip and the finger 12, and thus affecting the reliability of the 0-busbar solar cell 10 and the whole photovoltaic module. Therefore, by configuring the length of the second connection portion 132 as described above, it is beneficial to improving the connection stability of the solder strip and the finger 12 while ensuring the current transmission performance of the 0-busbar solar cell 10, reducing the light shielding area of the connection part 13, and thus improving the photoelectric conversion efficiency of the photovoltaic module.

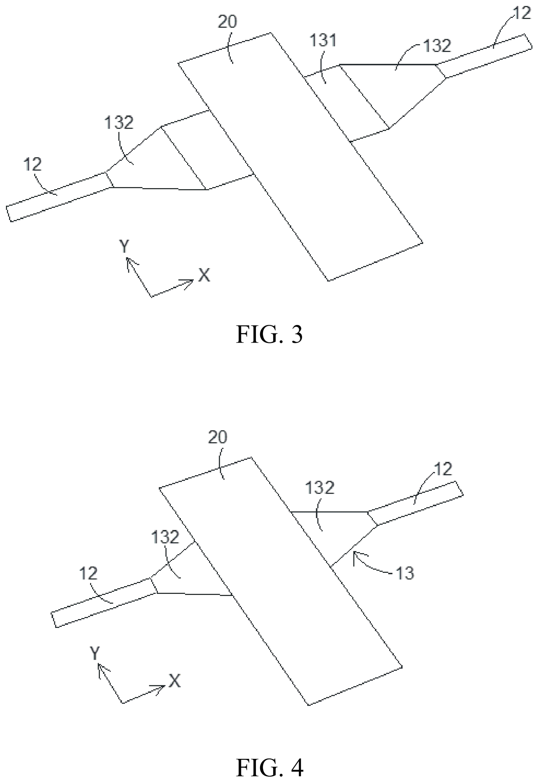

As shown in FIG. 3, in one or more embodiments, along the first direction X, the dimension of the first connection portion 131 is greater than a dimension of the solder strip 20.

The length of the first connection portion 131 may be greater than the width of the solder strip 20, so that the solder strip 20 may only be connected to the first connection portion 131 without being connected to the second connection portion 132, thereby maintaining a certain distance between the solder strip 20 and the finger 12, reducing a possibility of the breakage of the finger 12 during the soldering process due to direct contact between the solder strip 20 and the finger 12, improving the reliability of the photovoltaic module, and additionally, facilitating positioning of the solder strip 20, and thus facilitating the formation of the photovoltaic module.

As shown in FIG. 1 and FIG. 4, in one or more embodiments, along the first direction X, a dimension of the connection part 13 is greater than a dimension of the solder strip 20, and a dimension of the first connection portion 131 is smaller than the dimension of the solder strip 20.

The entire length of the connection part 13 is greater than the width of the solder strip 20, and the length of the first connection portion 131 may be smaller than the width of the solder strip 20. That is, both the first connection portion 131 and the second connection portion 132 may be connected to the solder strip 20, as long as it is ensured that the solder strip 20 and the finger 12 maintain a certain distance. Such a design is advantageous for the current transmission, reducing the current loss while ensuring the stability and the reliability of the connection between the solder strip 20 and the connection part 13, thereby ensuring the reliability of the 0-busbar solar cell 10.

As shown in FIG. 1, in one or more embodiments, a dimension H of the connection part 13 along the third direction Z is within a range of 3µm≤H≤8µm.

The thickness H (i.e., the dimension along the third direction Z) of the connection part 13 may be 3µm, 3.5µm, 4µm, 4.5µm, 5µm, 5.5µm, 6µm, 6.5µm, 7µm, 7.5µm or 8µm, or may be other values within the above-mentioned range. If the thickness of the connection part 13 is too small, it will result in poor mechanical property of connection part 13, which is prone to breakage during the connection process with the solder strip, thereby affecting the transmission of current. If the thickness of the connection part 13 is too large, it will cause waste of metal paste, increasing the production cost of the 0-busbar solar cell 10, and additionally, increasing the light shielding area of the connection part 13, and thus affecting the photoelectric conversion efficiency of the 0-busbar solar cell 10. Therefore, by configuring the thickness of the connection part 13 to be within a range from 3um to 8µm, the stability and reliability of the structure of the connection part 13 are ensured while ensuring the photoelectric conversion efficiency of the 0-busbar solar cell 10, thereby achieving the stable and reliable connection between the solder strip and the connection part 13, and thus improving the performance of the 0-busbar solar cell 10.

As shown in FIG. 1, in one or more embodiments, a dimension W of the finger 12 along the second direction Y is within a range of 10µm≤W≤20µm.

The width W (that is, the dimension along the second direction Y) of the finger 12 may be 10µm, 11µm, 12µm, 13µm, 14µm, 15µm, 16µm, 17µm, 18µm, 19µm or 20µm, or may be other values within the above-mentioned range. By limiting the width of finger 12, a sufficient contact area between finger 12 and connection part 13 can be ensured, thereby improving the stability and reliability of the connection between finger 12 and connection part 13, and additionally, reducing the light-shielding area of finger 12 to ensure the photoelectric conversion efficiency of the 0-busbar solar cell 10, and further enhancing the current collection and transmission capability of the finger 12.

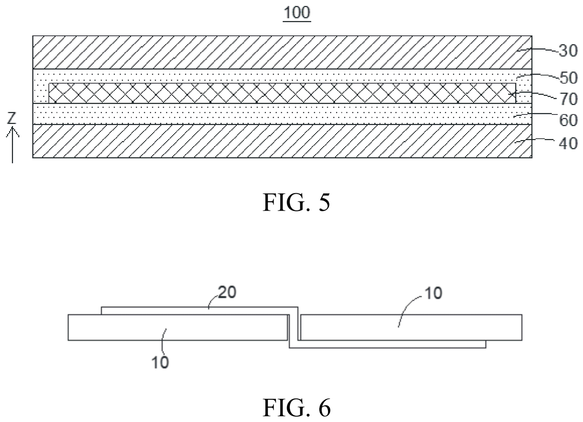

As shown in FIG. 1, FIG. 5, and FIG. 6, one or more embodiments of the present disclosure provides a photovoltaic module 100. The photovoltaic module 100 includes a cover plate, an encapsulation layer, and a solar cell string 70. The cover plate is connected to the solar cell string 70 through the encapsulation layer. The solar cell string 70 includes a plurality of the 0-busbar solar cells 10 described above. Adjacent 0-busbar solar cells 10 are connected through a solder strip 20. The solder strip 20 is soldered to a connection part 13 to achieve electrical connection between the solder strip 20 and the finger 12.

A cover plate located at an upper layer of the photovoltaic module 100 is the first cover plate 30, and a cover plate located at a lower layer of the photovoltaic module 100 is the second cover plate 40. An encapsulation layer between the first cover plate 30 and the solar cell string 70 is the first encapsulation layer 50, and an encapsulation layer between the second cover plate 40 and the solar cell string 70 is the second encapsulation layer 60. The first cover plate 30, the first encapsulation layer 50, the cell string 70, the second encapsulation layer 60, and the second cover plate 40 may be arranged along the thickness direction Z of the photovoltaic module 100 and laminated together. The first cover plate 30 may be a glass cover plate, and the first cover plate 30 has a relatively high light transmittance. The first encapsulation layer 50 bonds the first cover plate 30 and the solar cell string 70 together to provide encapsulation and protection for the solar cell string 70. The material of the first encapsulation layer 50 may be one or more of ethylene-vinyl acetate copolymer (EVA), polyolefin elastomer (POE), and polyvinyl butyral (PVB). The second encapsulation layer 60 connects the solar cell layer and the second cover plate 40 together, which also provides encapsulation and protection for the solar cell string 70. The material of the second encapsulation layer 60 may be one or more of EVA, POE, and PVB as described above. The material of the second cover plate 40 may be glass, or the second cover plate 40 may be formed by compounding a plurality of polymer film layers.

As mentioned above, during the forming process of the photovoltaic module 100, the solder strip 20 is soldered to the connection part 13, that is, the solder strip 20 is alloyed with the connection part 13, so that the current collected by the finger 12 is transmitted to the solder strip 20 through the connection part 13 and then output through the solder strip 20. That is, the solder strip 20 is electrically connected to the finger 12 through the connection part 13. The solder strip 20 is connected to the finger 12 by alloying with the connection part 13. That is, the finger 12 does not need to be directly soldered to the solder strip 20, thereby reducing the possibility of the breakage of the finger 12 due to the stress concentration at the joint between the finger 12 and the solder strip 20, thus improving the reliability of the photovoltaic module 100 and achieving the normal and stable operation of the photovoltaic module 100.

In some embodiments of the present disclosure, types of the 0-busbar solar cell include but are not limited to a Passivated Emitter Rear Cell (PERC), a Tunnel Oxide Passivated Contact (TOPCon) cell, a Heterojunction with Intrinsic Thin-film (HJT) cell, an Interdigitated Back Contact (IBC) cell, a perovskite cell, and the like.

For the PERC solar cell, along a thickness direction thereof, the PERC solar cell sequentially includes a front-surface metal silver electrode, a front-surface silicon nitride passivation layer, a phosphor layer emitter, a P-type substrate silicon layer, a local aluminum back field, a metal aluminum back electrode, and a back passivation layer (Al₂O₃/SiNₓ). In the PERC solar cell, a passivation film is used to perform passivation on the back surface to replace an all-aluminum back field, thereby enhancing the internal back reflection of light on a silicon substrate, reducing a recombination rate on the back surface, and increasing the efficiency of the solar cell by 0.5% to 1%.

For the TOPCon cell, along a thickness direction thereof, the TOPCon cell sequentially includes a metal silver electrode, a front-surface silicon nitride passivation layer, a boron-doped emitter, an N-type substrate silicon layer, a diffusion doping layer, an ultra-thin silicon oxide, a doped polysilicon, a silicon nitride, and a metal silver electrode. The back surface of the solar cell is formed by a layer of ultra-thin silicon oxide (1nm to 2nm) and a layer of phosphorus-doped microcrystalline amorphous mixed Si film, which jointly form a passivated contact structure. The structure may prevent recombination of minority carriers and holes, and thus increase an open-circuit voltage and a short-circuit current of the solar cell. The ultra-thin oxide layer may block the recombination of the minority electrons and holes while allowing majority carriers and electrons to tunnel into a polysilicon layer. A good passivation effect of the ultra-thin silicon oxide and a heavily doped silicon film causes a surface energy band of a silicon wafer to bend, so as to form field passivation effect, which greatly increases the probability of electron tunneling, reduces the contact resistance, and improves the open-circuit voltage and the short-circuit current of the solar cell, thereby improving the conversion efficiency of the solar cell.

For the HJT cell, along a thickness direction thereof, the HJT cell sequentially includes a front low-temperature silver electrode, a front conductive film, an N-type amorphous silicon film, an intrinsic amorphous silicon film, an N-type substrate 10 silicon layer, a P-type amorphous silicon film, a back conductive film, and a back low-temperature silver electrode.

For the IBC cell, along the thickness direction thereof, the IBC cell sequentially includes a silicon nitride anti-layer, an N+ front surface field, an N-type substrate silicon layer, a P+ emitter, an N+ back field, an aluminum oxide passivation layer, a silicon nitride anti-reflection layer, and a metal silver electrode. The IBC cell can obtain a P-region and an N-region with good uniformity and precisely controllable junction depth using an ion implantation technology. The front surface of the solar cell is free of electrode line shading, which can eliminate the shading current loss of the metal electrode, and realize the maximum utilization of incident photons, so that the short circuit current can be increased by about 7% compared with the conventional solar cell. Due to the back contact structure, the problem of electrode line shading does not need to be considered, and the proportion of the electrode lines can be appropriately widened, thereby reducing the series resistance and achieving a high fill factor. The surface passivation and surface light trapping structures can be optimally designed, to obtain a relatively low front surface recombination rate and surface reflection.

For the perovskite cell, along a thickness direction thereof, the perovskite cell sequentially includes a substrate material, a conductive film, an electron transport layer (titanium dioxide), a perovskite absorption layer (hole transport layer), and a metal cathode. The perovskite material has a relatively high light absorption coefficient and a relatively long carrier diffusion distance. After photons absorbed by the perovskite material are converted into electrons, they are easily collected by an electrode with lower loss, thereby generating a relatively high photo-voltage and photo-current, so that the perovskite cell exhibits relatively high photoelectric conversion efficiency.

## Claims

1. A solar cell, comprising a substrate, wherein
the substrate is provided with fingers, the fingers are arranged at intervals along a first direction, a connection part is disposed between and connected to two adjacent fingers, and the connection part is configured to be connected to a solder strip; and
the connection part comprises a first connection portion and second connection portions, the second connection portions are connected to two ends of the first connection portion along the first direction, a dimension of each of the two second connection portions in a second direction gradually decreases along a direction away from the first connection portion, and the finger is connected to an end of each of the two second connection portions away from the substrate along a third direction.

2. The solar cell according to claim 1, wherein
the first direction intersects with the second direction, and both the first direction and the second direction are perpendicular to the third direction; and the first direction is a length direction of the solar cell, the second direction is a width direction of the solar cell, and the third direction is a thickness direction of the solar cell.

3. The solar cell according to claim 1, wherein
the substrate is provided with a plurality of fingers and a plurality of connection parts, the plurality of fingers and the plurality of connection parts are formed on the substrate by printing metal paste, and the plurality of fingers and the plurality of connection parts are in ohmic contact with the substrate.

4. The solar cell according to claim 1, wherein
a projection of the first connection portion along the third direction is a circle or a polygon.

5. The solar cell according to claim 1, wherein
a projection of the first connection portion along the third direction is rectangular; and
a dimension of the first connection portion along the first direction is greater than a dimension of the first connection portion along the second direction.

6. The solar cell according to claim 5, wherein
a dimension a of the first connection portion along the first direction satisfies: $0.4 mm \leq a \leq 1.2 mm .$

7. The solar cell according to claim 6, wherein
the dimension a of the first connection portion along the first direction is equal to 0.4mm, 0.5mm, 0.6mm, 0.7mm, 0.8mm, 0.9mm, 1mm, 1.1mm or 1.2mm.

8. The solar cell according to claim 5, wherein
a dimension b of the first connection portion along the second direction satisfies: 0.04mm≤b≤0.2mm.

9. The solar cell according to claim 1, wherein
the second connection portion comprises a first edge and a second edge, the first edge comprises a first reference point, the second edge comprises a second reference point, and the first reference point and the second reference point are arranged along the second direction; and
a distance between the first reference point and the second reference point is h; a distance from each of the first reference point and the second reference point to the first connection portion along the first direction is d; a dimension of the first connection portion along the second direction is b; where h, d and b satisfy h=-kd+b, and k is within a range of -0.08≤k≤1.

10. The solar cell according to claim 9, wherein a dimension c of the second connection portion along the first direction is within a range of 0.1mm≤c≤0.5mm.

11. The solar cell according to any one of claims 1 to 5, wherein along the first direction, the dimension of the first connection portion is greater than a dimension of the solder strip.

12. The solar cell according to any one of claims 1 to 5, wherein along the first direction, a dimension of the connection part is greater than a dimension of the solder strip, and a dimension of the first connection portion is smaller than a dimension of the solder strip.

13. The solar cell according to any one of claims 1 to 5, wherein a dimension H of the connection part along the third direction is within a range of 3µm≤H≤8µm.

14. The solar cell according to any one of claims 1 to 5, wherein a dimension W of the finger along the second direction is within a range of 10um≤W≤20um.

15. A photovoltaic module, comprising a cover plate, an encapsulation layer, and a solar cell string, wherein
the cover plate is connected to the solar cell string through the encapsulation layer; and
the solar cell string comprises a plurality of solar cells according to any one of claims 1 to 14, adjacent solar cells are connected to each other through a solder strip, wherein the solder strip is soldered to the connection part to electrically connect the solder strip and the finger.
